# EUROPÄISCHE PATENTSCHRIFT

(11) **EP 3 753 109 B1**
(45) Veröffentlichungstag und Bekanntmachung des Hinweises auf die Patenterteilung: **14.06.2023**
(21) Anmeldenummer: 18720167.8
(22) Anmeldetag: 16.04.2018
(51) Int. Cl.: H03K 19/003, H05K 7/14

(54) **SCHALTUNGSANORDNUNG UND STROMRICHTERMODUL MIT IN REIHE GESCHALTETEN SCHALTERBAUGRUPPEN**
SWITCHING CIRCUIT AND RECTIFIERMODULE WITH IN SERIES CONNECTED SWITCHING DEVICES
CIRCUIT ET MODULE DE CONVERTISSEUR DE COURANT AVEC DES INTERRUPTEURS CONNECTÉS EN SERIE

(43) Veröffentlichungstag der Anmeldung: 23.12.2020
(73) Patentinhaber: Siemens Energy Global GmbH & Co. KG, 81739 München (DE)
(72) Erfinder: DÖRING, David, 91074 Herzogenaurach (DE); GIERING, Gerald Franz, 90562 Kalchreuth (DE); WÜRFLINGER, Klaus, 90419 Nürnberg (DE)
(86) Internationale Anmeldenummer: PCT/EP2018/059669
(87) Internationale Veröffentlichungsnummer: WO 2019/201420

(56) Entgegenhaltungen:
- EP-A1- 2 996 449
- EP-A1- 3 002 866
- GB-A- 2 438 464

## Beschreibung

Die Erfindung betrifft eine Schaltungsanordnung, die in Reihe geschaltete Schalterbaugruppen mit jeweils einem Halbleiterschalter aufweist, und ein Stromrichtermodul mit einer derartigen Schaltungsanordnung.

Halbleiterschalter wie ein Bipolartransistor mit isoliertem Gate (IGBT = Insulated-Gate Bipolar Transistor) werden durch einen Treiber angesteuert, der mit elektrischer Energie versorgt werden muss. Insbesondere Stromrichtermodule weisen häufig eine Reihenschaltung von Schalterbaugruppen mit jeweils einem Halbleiterschalter auf. Dokument EP 2 996 449 A1 beschreibt in Figur 1 eine Stromrichteranordnung mit einem mehrphasigen Stromrichter, der für jede Stromrichterphase mehrere elektrisch miteinander verschaltete Stromrichtermodule umfasst, und in Figur 2 einen Stromrichterschrank, in dem der Stromrichter angeordnet ist. Dokument GB 2 438 464 A beschreibt in Figur 1 eine Schaltungsanordnung für ein Schaltnetzteil.

Die Erfindung betrifft insbesondere die Energieversorgung der Treiber der Halbleiterschalter einer derartigen Reihenschaltung. Ein Treiber eines einzelnen Halbleiterschalters wird beispielsweise häufig aus einem mit dem Halbleiterschalter verbundenen Kondensator mit Energie versorgt. Diese Art der Energieversorgung eines Treibers eines Halbleiterschalters ist jedoch bei einer Reihenschaltung von Schalterbaugruppen mit Schwierigkeiten verbunden, weil eine Energieauskopplung entweder aus einer Kondensatorschaltung für die gesamte Reihenschaltung der Schalterbaugruppen und damit aus einer in der Regel sehr hohen Spannung oder aus nur einem Kondensator mehrerer in Reihe geschalteter Kondensatoren, deren Spannungen Schwankungen der Spannungsaufteilung zwischen den Kondensatoren unterliegen, erfolgt.

Der Erfindung liegt die Aufgabe zugrunde, eine Schaltungsanordnung und ein Stromrichtermodul anzugeben, die in Reihe geschaltete Schalterbaugruppen mit jeweils einem Halbleiterschalter aufweisen und insbesondere hinsichtlich der Energieversorgung der Treiber der Halbleiterschalter verbessert sind.

Die Aufgabe wird erfindungsgemäß durch eine Schaltungsanordnung mit den Merkmalen des Anspruchs 1 und ein Stromrichtermodul mit den Merkmalen des Anspruchs 8 gelöst.

Vorteilhafte Ausgestaltungen der Erfindung sind Gegenstand der Unteransprüche.

Eine erfindungsgemäße Schaltungsanordnung (3), umfasst
- mehrere in Reihe geschaltete erste Schalterbaugruppen (9), die eine erste Schaltgruppenreihenschaltung (7) bilden,
- eine mit der Anzahl erster Schalterbaugruppen (9) übereinstimmende Anzahl in Reihe geschalteter zweiter Schalterbaugruppen (10), die eine zweite Schaltgruppenreihenschaltung (8) bilden,
- eine mit der Anzahl erster Schalterbaugruppen (9) übereinstimmende Anzahl von Schaltnetzteilen (11) und
- zwei jeweils wenigstens einen Kondensator (25) aufweisende Kondensatorbrücken (5, 6), wobei
- jede Schalterbaugruppe (9, 10) einen Halbleiterschalter (13) mit einem Steueranschluss (21) und zwei Lastanschlüssen (19, 20) und einen Treiber (17) zur Ansteuerung des Halbleiterschalters (13) über dessen Steueranschluss (21) aufweist, wobei jeder Halbleiterschalter (13) ein Bipolartransistor mit isoliertem Gate ist, dessen Lastanschlüsse (19, 20) sein Emitter und sein Kollektor sind und dessen Steueranschluss (21) sein Gate ist, und die Halbleiterschalter (13) je zweier in einer Schaltgruppenreihenschaltung (7, 8) aufeinander folgender Schalterbaugruppen (9, 10) durch eine elektrische Verbindung des Emitters eines der beiden Halbleiterschalter (13) und des Kollektors des anderen der beiden Halbleiterschalter (13) elektrisch miteinander verbunden sind,
- eine erste Kondensatorbrücke (5) mit dem Kollektor des Halbleiterschalters (13) der Schalterbaugruppe (9) an einem ersten Ende der ersten Schaltgruppenreihenschaltung (7) und dem Emitter des Halbleiterschalters (13) der Schalterbaugruppe (10) an einem ersten Ende der zweiten Schaltgruppenreihenschaltung (8) elektrisch verbunden ist,
- die zweite Kondensatorbrücke (6) mit dem Emitter des Halbleiterschalters (13) der Schalterbaugruppe (9) an dem zweiten Ende der ersten Schaltgruppenreihenschaltung (7) und dem Kollektor des Halbleiterschalters (13) der Schalterbaugruppe (10) an dem zweiten Ende der zweiten Schaltgruppenreihenschaltung (8) elektrisch verbunden ist,
- jedes Schaltnetzteil (11) einem Schalterpaar von Halbleiterschaltern (13) zugeordnet ist und die Treiber (17) beider Halbleiterschalter (13) des Schalterpaares mit Energie versorgt, wobei jedes Schalterpaar von dem Halbleiterschalter (13) einer ersten Schalterbaugruppe (9) und dem Halbleiterschalter (13) derjenigen zweiten Schalterbaugruppe (10), deren Position in der zweiten Schaltgruppenreihenschaltung (8) bezogen auf deren erstes Ende zu der Position der ersten Schalterbaugruppe (9) in der ersten Schaltgruppenreihenschaltung (7) bezogen auf deren erstes Ende korrespondiert, gebildet wird, und- jedes Schaltnetzteil (11) von einem Halbleiterschalter (13) desjenigen Schalterpaares, dem das Schaltnetzteil (11) zugeordnet ist, mit Energie aus einer elektrischen Spannung zwischen den Lastanschlüssen (19, 20) des Halbleiterschalters (13) versorgt wird.

Die Erfindung sieht also vor, die Treiber der Halbleiterschalter der Schalterbaugruppen paarweise durch jeweils ein Schaltnetzteil mit Energie zu versorgen. Dabei sind die beiden Halbleiterschalter, deren Treiber von demselben Schaltnetzteil mit Energie versorgt werden, an zueinander korrespondierenden Positionen in zwei Schaltgruppenreihenschaltungen der Schalterbaugruppen angeordnet, die miteinander durch zwei Kondensatorbrücken verbunden sind. Die Erfindung berücksichtigt, dass einander entsprechende Lastanschlüsse voneinander verschiedener Halbleiterschalter bei einer Reihenschaltung der Halbleiterschalter auf voneinander verschiedenen elektrischen Potentialen liegen. Bei einer gemeinsamen Energieversorgung der Treiber zweier Halbleiterschalter durch jeweils ein gemeinsames Schaltnetzteil muss diese Potentialdifferenz von dem Schaltnetzteil ausgeglichen werden. Es ist daher vorteilhaft, die Potentialdifferenz zwischen den beiden Halbleiterschaltern jedes von einem Schaltnetzteil versorgten Schalterpaares möglichst klein zu halten. Dies wird durch die erfindungsgemäße Anordnung der Schalterbaugruppen in zwei durch zwei Kondensatorbrücken verbundenen Schaltgruppenreihenschaltungen mit zueinander korrespondierenden Positionen der Halbleiterschalter eines Schalterpaares in den beiden Schaltgruppenreihenschaltungen erreicht.

Eine Ausgestaltung der Erfindung sieht vor, dass die ersten Schalterbaugruppen räumlich übereinander oder nebeneinander in einem ersten Baugruppenstapel angeordnet sind und die zweiten Schalterbaugruppen zu den ersten Schalterbaugruppen korrespondierend, das heißt übereinander oder nebeneinander wie die ersten Schalterbaugruppen, in einem zweiten Baugruppenstapel angeordnet sind. Vorzugsweise sind die Schalterbaugruppen jedes Baugruppenstapels dabei in der Reihenfolge ihrer Schaltgruppenreihenschaltung übereinander oder nebeneinander angeordnet. Dadurch wird die räumliche Anordnung der Schalterbaugruppen vorteilhaft der elektrischen Verschaltung der Schalterbaugruppen angepasst. Dies ermöglicht insbesondere eine besonders einfache Realisierung der Verschaltung der Schalterbaugruppen der Baugruppenstapel.

Die Erfindung sieht vor, dass jedes Schaltnetzteil von einem Halbleiterschalter desjenigen Schalterpaares, dem das Schaltnetzteil zugeordnet ist, mit Energie aus einer elektrischen Spannung zwischen den Lastanschlüssen des Halbleiterschalters versorgt wird. Beispielsweise wird jedes Schaltnetzteil dabei von dem Halbleiterschalter einer ersten Schalterbaugruppe mit Energie versorgt. Gemäß der Erfindung wird eine Spannung, die an einem Halbleiterschalter eines Schalterpaares anliegt, genutzt, um das Schaltnetzteil des jeweiligen Schalterpaares mit Energie zu versorgen. Dadurch entfallen die oben genannten Probleme, die bei einer Energieversorgung der Treiber der Halbleiterschalter aus einer Kondensatorschaltung auftreten.

Eine weitere Ausgestaltung der Erfindung sieht vor, dass jede Schalterbaugruppe eine parallel zu dem Halbleiterschalter geschaltete Freilaufdiode aufweist. Dadurch werden die Halbleiterschalter vor Überspannungen bei Änderungen ihrer Schaltzustände geschützt.

Bei der Erfindung ist jeder Halbleiterschalter ein Bipolartransistor mit isoliertem Gate (IGBT), dessen Lastanschlüsse sein Emitter und sein Kollektor sind und dessen Steueranschluss sein Gate ist. Dabei sind die Halbleiterschalter je zweier in ihrer Reihenschaltung aufeinander folgender Schalterbaugruppen durch eine elektrische Verbindung des Emitters eines der beiden Halbleiterschalter und des Kollektors des anderen der beiden Halbleiterschalter elektrisch miteinander verbunden. Bipolartransistoren mit isoliertem Gate vereinigen Vorteile von Bipolartransistoren und Feldeffekttransistoren und sind daher besonders geeignete Halbleiterschalter, insbesondere für Schaltungsanordnungen für Stromrichtermodule.

Weitere Ausgestaltungen der Erfindung sehen vor, dass jede Kondensatorbrücke eine Reihenschaltung mehrerer Kondensatoren aufweist, und/oder dass die Kondensatorbrücken identisch ausgebildet sind. Durch eine Reihenschaltung von Kondensatoren kann eine hohe Spannung auf mehrere Kondensatoren aufgeteilt werden und somit können vorteilhaft kleinere und kostengünstigere Kondensatoren mit geringerer Spannungsfestigkeit als bei Kondensatorbrücken mit nur jeweils einem Kondensator verwendet werden. Eine identische Ausbildung der Kondensatorbrücken realisiert eine symmetrische Ausführung der Schaltungsanordnung und reduziert die Bauelementvielfalt gegenüber einer Ausbildung der Kondensatorbrücken mit voneinander verschiedenen Kondensatoren.

Ein erfindungsgemäßes Stromrichtermodul umfasst eine erfindungsgemäße Schaltungsanordnung und zwei Modulanschlüsse. Ein erster Modulanschluss ist mit dem ersten Ende der ersten Schaltgruppenreihenschaltung elektrisch verbunden. Der zweite Modulanschluss ist mit dem zweiten Ende der ersten Schaltgruppenreihenschaltung elektrisch verbunden. Die Vorteile eines erfindungsgemäßen Stromrichtermoduls ergeben sich aus den oben genannten Vorteilen einer erfindungsgemäßen Schaltungsanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines Stromrichtermoduls,
- FIG 2: eine räumliche Anordnung von Schalterbaugruppen eines Stromrichtermoduls.

Einander entsprechende Teile sind in den Figuren mit denselben Bezugszeichen versehen.

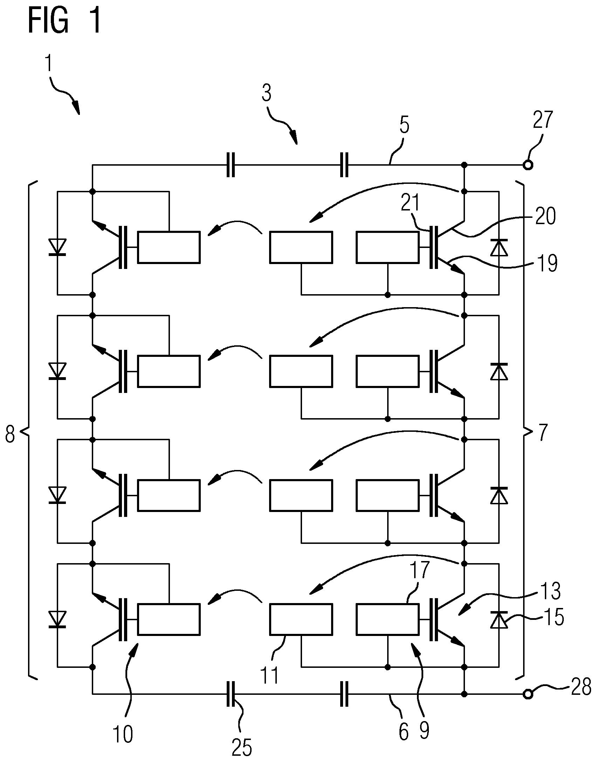

Figur 1 zeigt einen Schaltplan eines erfindungsgemäßen Stromrichtermoduls 1. Das Stromrichtermodul 1 umfasst eine erfindungsgemäße Schaltungsanordnung 3 und zwei Modulanschlüsse 27, 28.

Die Schaltungsanordnung 3 umfasst vier in Reihe geschaltete erste Schalterbaugruppen 9, die eine erste Schaltgruppenreihenschaltung 7 bilden, vier in Reihe geschaltete zweite Schalterbaugruppen 10, die eine zweite Schaltgruppenreihenschaltung 8 bilden, vier Schaltnetzteile 11 und zwei Kondensatorbrücken 5, 6. Jede Schalterbaugruppe 9, 10 weist eine Parallelschaltung eines Halbleiterschalters 13 und einer Freilaufdiode 15 sowie einen Treiber 17 zur Ansteuerung des Halbleiterschalters 13 auf.

Jeder Halbleiterschalter 13 ist als ein IGBT ausgebildet und weist zwei Lastanschlüsse 19, 20 und einen Steueranschluss 21, über den der Halbleiterschalter 13 mit dem Treiber 17 angesteuert wird, auf. Ein erster Lastanschluss 19 ist der Emitter des IGBT, der zweite Lastanschluss 20 ist der Kollektor des IGBT, der Steueranschluss 21 ist das Gate des IGBT.

Jede Kondensatorbrücke 5, 6 weist zwei in Reihe geschaltete Kondensatoren 25 auf. Eine erste Kondensatorbrücke 5 ist mit einem ersten Ende der ersten Schaltgruppenreihenschaltung 7 und einem ersten Ende der zweiten Schaltgruppenreihenschaltung 8 elektrisch verbunden. Die zweite Kondensatorbrücke 6 ist mit dem zweiten Ende der ersten Schaltgruppenreihenschaltung 7 und dem zweiten Ende der zweiten Schaltgruppenreihenschaltung 8 elektrisch verbunden.

Jedes Schaltnetzteil 11 ist einem Schalterpaar von Halbleiterschaltern 13 zugeordnet und versorgt die Treiber 17 beider Halbleiterschalter 13 des Schalterpaares mit Energie. Jedes Schalterpaar wird von dem Halbleiterschalter 13 einer ersten Schalterbaugruppe 9 und dem Halbleiterschalter 13 derjenigen zweiten Schalterbaugruppe 10, deren Position in der zweiten Schaltgruppenreihenschaltung 8 bezogen auf deren erstes Ende zu der Position der ersten Schalterbaugruppe 9 in der ersten Schaltgruppenreihenschaltung 7 bezogen auf deren erstes Ende korrespondiert, gebildet.

Jedes Schaltnetzteil 11 wird von dem Halbleiterschalter 13 der ersten Schalterbaugruppe 9 desjenigen Schalterpaares, dem das Schaltnetzteil 11 zugeordnet ist, mit Energie aus einer elektrischen Spannung zwischen den Lastanschlüssen 19, 20 des Halbleiterschalters 13 versorgt. Das Schaltnetzteil 11 ist dazu ausgebildet, die zwischen den beiden Lastanschlüssen 19, 20 anliegende Spannung zu messen und Energie aus dieser Spannung auszukoppeln, wenn der Halbleiterschalter 13 abgeschaltet (sperrend) ist und die Freilaufdiode 15 nicht leitet. Ferner berücksichtigt das Schaltnetzteil 11 eine Potentialdifferenz zwischen den einander entsprechenden Lastanschlüssen 19, 20 (beispielsweise zwischen den Emittern 19) der beiden Halbleiterschalter 13, deren Treiber 17 es mit Energie versorgt. Die zueinander korrespondierende Anordnung der beiden Halbleiterschalter 13 eines Schalterpaares in den beiden Schaltgruppenreihenschaltungen 7, 8 bewirkt vorteilhaft eine relativ geringe Potentialdifferenz zwischen den beiden Halbleiterschaltern 13 des Schalterpaares. Die Energieversorgung der Schaltnetzteile 11 jeweils durch die Spannung an einem Halbleiterschalter 13 einer ersten Schalterbaugruppe 9 und die Energieversorgung der Treiber 17 der Halbleiterschalter 13 der zweiten Schalterbaugruppe 10 durch jeweils ein Schaltnetzteil 11 sind in Figur 1 jeweils durch einen Pfeil angedeutet.

Die Halbleiterschalter 13 je zweier in einer Schaltgruppenreihenschaltung 7, 8 aufeinander folgender Schalterbaugruppen 9, 10 sind durch eine elektrische Verbindung des Emitters 19 eines der beiden Halbleiterschalter 13 und des Kollektors 20 des anderen der beiden Halbleiterschalter 13 elektrisch miteinander verbunden.

Die Anode der Freilaufdiode 15 einer Schalterbaugruppe 9, 10 ist mit dem Emitter 19 des Halbleiterschalters 13 der Schalterbaugruppe 9, 10 verbunden. Die Kathode der Freilaufdiode 15 einer Schalterbaugruppe 9, 10 ist mit dem Kollektor 20 des Halbleiterschalters 13 der Schalterbaugruppe 9, 10 verbunden.

Ein erster Modulanschluss 27 ist mit dem ersten Ende der ersten Schaltgruppenreihenschaltung 7 verbunden. Der zweite Modulanschluss 28 ist mit dem zweiten Ende der ersten Schaltgruppenreihenschaltung 7 verbunden.

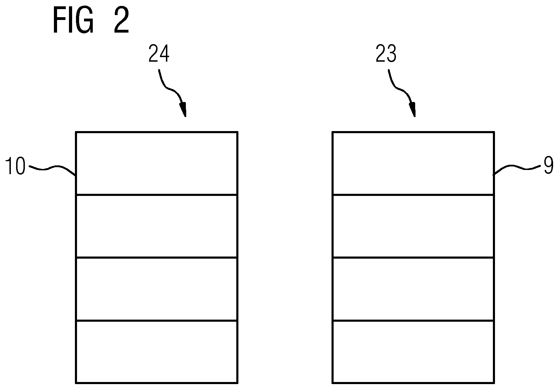

Figur 2 zeigt die räumliche Anordnung der Schalterbaugruppen 9, 10. Die ersten Schalterbaugruppen 9 sind übereinander in einem ersten Baugruppenstapel 23 angeordnet. Die zweiten Schalterbaugruppen 10 sind übereinander in einem zweiten Baugruppenstapel 24 angeordnet. Die beiden Baugruppenstapel 23, 24 sind nebeneinander angeordnet. Die Schalterbaugruppen 9, 10 jedes Baugruppenstapels 23, 24 sind in der Reihenfolge ihrer Schaltgruppenreihenschaltung 7, 8 übereinander angeordnet.

Die in den Figuren 1 und 2 gezeigten Ausführungsbeispiele einer Schaltungsanordnung 3 und eines Stromrichtermoduls 1 können auf verschiedene Weisen abgewandelt werden. Beispielsweise kann eine von Vier verschiedene Anzahl von ersten Schalterbaugruppen 9, zweiten Schalterbaugruppen 10 und Schaltnetzteilen 11 und/oder eine von Zwei verschiedene Anzahl von Kondensatoren 25 in den Kondensatorbrücken 5, 6 vorgesehen sein. Ferner kann vorgesehen sein, zusätzlich zu der Energieversorgung der Schaltnetzteile 11 aus an den Halbleiterschaltern 13 der ersten Schalterbaugruppen 9 anliegenden Spannungen eine redundante Energieversorgung der Schaltnetzteile 11, beispielsweise aus einem Strom oder den Kondensatorbrücken 5, 6 zu ermöglichen, die bedarfsweise genutzt werden kann.

Obwohl die Erfindung im Detail durch bevorzugte Ausführungsbeispiele näher illustriert und beschrieben wurde, ist die Erfindung durch die Merkmale der Ansprüche definiert.

### Bezugszeichenliste

- 1: Stromrichtermodul
- 3: Schaltungsanordnung
- 5, 6: Kondensatorbrücke
- 7, 8: Schaltgruppenreihenschaltung
- 9, 10: Schalterbaugruppe
- 11: Schaltnetzteil
- 13: Halbleiterschalter
- 15: Freilaufdiode
- 17: Treiber
- 19, 20: Lastanschluss
- 21: Steueranschluss
- 23, 24: Baugruppenstapel
- 25: Kondensator
- 27, 28: Modulanschluss

## Patentansprüche

1. Schaltungsanordnung (3), umfassend
- mehrere in Reihe geschaltete erste Schalterbaugruppen (9), die eine erste Schaltgruppenreihenschaltung (7) bilden,
- eine mit der Anzahl erster Schalterbaugruppen (9) übereinstimmende Anzahl in Reihe geschalteter zweiter Schalterbaugruppen (10), die eine zweite Schaltgruppenreihenschaltung (8) bilden,
- eine mit der Anzahl erster Schalterbaugruppen (9) übereinstimmende Anzahl von Schaltnetzteilen (11) und
- zwei jeweils wenigstens einen Kondensator (25) aufweisende Kondensatorbrücken (5, 6), wobei
- jede Schalterbaugruppe (9, 10) einen Halbleiterschalter (13) mit einem Steueranschluss (21) und zwei Lastanschlüssen (19, 20) und einen Treiber (17) zur Ansteuerung des Halbleiterschalters (13) über dessen Steueranschluss (21) aufweist, wobei jeder Halbleiterschalter (13) ein Bipolartransistor mit isoliertem Gate ist, dessen Lastanschlüsse (19, 20) sein Emitter und sein Kollektor sind und dessen Steueranschluss (21) sein Gate ist, und die Halbleiterschalter (13) je zweier in einer Schaltgruppenreihenschaltung (7, 8) aufeinander folgender Schalterbaugruppen (9, 10) durch eine elektrische Verbindung des Emitters eines der beiden Halbleiterschalter (13) und des Kollektors des anderen der beiden Halbleiterschalter (13) elektrisch miteinander verbunden sind,
- eine erste Kondensatorbrücke (5) mit dem Kollektor des Halbleiterschalters (13) der Schalterbaugruppe (9) an einem ersten Ende der ersten Schaltgruppenreihenschaltung (7) und dem Emitter des Halbleiterschalters (13) der Schalterbaugruppe (10) an einem ersten Ende der zweiten Schaltgruppenreihenschaltung (8) elektrisch verbunden ist,
- die zweite Kondensatorbrücke (6) mit dem Emitter des Halbleiterschalters (13) der Schalterbaugruppe (9) an dem zweiten Ende der ersten Schaltgruppenreihenschaltung (7) und dem Kollektor des Halbleiterschalters (13) der Schalterbaugruppe (10) an dem zweiten Ende der zweiten Schaltgruppenreihenschaltung (8) elektrisch verbunden ist,
- jedes Schaltnetzteil (11) einem Schalterpaar von Halbleiterschaltern (13) zugeordnet ist und die Treiber (17) beider Halbleiterschalter (13) des Schalterpaares mit Energie versorgt, wobei jedes Schalterpaar von dem Halbleiterschalter (13) einer ersten Schalterbaugruppe (9) und dem Halbleiterschalter (13) derjenigen zweiten Schalterbaugruppe (10), deren Position in der zweiten Schaltgruppenreihenschaltung (8) bezogen auf deren erstes Ende zu der Position der ersten Schalterbaugruppe (9) in der ersten Schaltgruppenreihenschaltung (7) bezogen auf deren erstes Ende korrespondiert, gebildet wird, und
- jedes Schaltnetzteil (11) von einem Halbleiterschalter (13) desjenigen Schalterpaares, dem das Schaltnetzteil (11) zugeordnet ist, mit Energie aus einer elektrischen Spannung zwischen den Lastanschlüssen (19, 20) des Halbleiterschalters (13) versorgt wird.

2. Schaltungsanordnung (3) nach Anspruch 1, wobei die ersten Schalterbaugruppen (9) räumlich übereinander oder nebeneinander in einem ersten Baugruppenstapel (23) angeordnet sind und die zweiten Schalterbaugruppen (10) zu den ersten Schalterbaugruppen (9) korrespondierend in einem zweiten Baugruppenstapel (24) angeordnet sind.

3. Schaltungsanordnung (3) nach Anspruch 2, wobei die Schalterbaugruppen (9, 10) jedes Baugruppenstapels (23, 24) in der Reihenfolge ihrer Schaltgruppenreihenschaltung (7, 8) übereinander oder nebeneinander angeordnet sind.

4. Schaltungsanordnung (3) nach einem der vorhergehenden Ansprüche, wobei jedes Schaltnetzteil (11) von dem Halbleiterschalter (13) einer ersten Schalterbaugruppe (9) mit Energie versorgt wird.

5. Schaltungsanordnung (3) nach einem der vorhergehenden Ansprüche, wobei jede Schalterbaugruppe (9, 10) eine parallel zu dem Halbleiterschalter (13) geschaltete Freilaufdiode (15) aufweist.

6. Schaltungsanordnung (3) nach einem der vorhergehenden Ansprüche, wobei jede Kondensatorbrücke (5, 6) eine Reihenschaltung mehrerer Kondensatoren (25) aufweist.

7. Schaltungsanordnung (3) nach einem der vorhergehenden Ansprüche, wobei die Kondensatorbrücken (5, 6) identisch ausgebildet sind.

8. Stromrichtermodul (1), umfassend
- eine Schaltungsanordnung (3) nach einem der vorhergehenden Ansprüche,
- einen ersten Modulanschluss (27), der mit dem ersten Ende der ersten Schaltgruppenreihenschaltung (7) elektrisch verbunden ist, und
- einen zweiten Modulanschluss (28), der mit dem zweiten Ende der ersten Schaltgruppenreihenschaltung (7) elektrisch verbunden ist.

## Claims

1. Circuit arrangement (3), comprising
- a plurality of first switch assemblies (9) connected in series, which form a first switching group series circuit (7),
- a number - corresponding to the number of first switch assemblies (9) - of second switch assemblies (10) connected in series, which form a second switching group series circuit (8),
- a number of switch-mode power supply units (11) corresponding to the number of first switch assemblies (9), and
- two capacitor bridges (5, 6) each having at least one capacitor (25), wherein
- each switch assembly (9, 10) has a semiconductor switch (13) having a control terminal (21) and two load terminals (19, 20) and a driver (17) for driving the semiconductor switch (13) via the control terminal (21) thereof, wherein each semiconductor switch (13) is an insulated gate bipolar transistor, the load terminals (19, 20) of which are its emitter and its collector and the control terminal (21) of which is its gate, and the semiconductor switches (13) of each two switch assemblies (9, 10) succeeding one another in a switching group series circuit (7, 8) are electrically connected to one another by an electrical connection of the emitter of one of the two semiconductor switches (13) and the collector of the other of the two semiconductor switches (13),
- a first capacitor bridge (5) is electrically connected to the collector of the semiconductor switch (13) of the switch assembly (9) at a first end of the first switching group series circuit (7) and to the emitter of the semiconductor switch (13) of the switch assembly (10) at a first end of the second switching group series circuit (8),
- the second capacitor bridge (6) is electrically connected to the emitter of the semiconductor switch (13) of the switch assembly (9) at the second end of the first switching group series circuit (7) and to the collector of the semiconductor switch (13) of the switch assembly (10) at the second end of the second switching group series circuit (8),
- each switch-mode power supply unit (11) is assigned to a switch pair of semiconductor switches (13) and supplies the drivers (17) of both semiconductor switches (13) of the switch pair with energy, wherein each switch pair is formed by the semiconductor switch (13) of a first switch assembly (9) and the semiconductor switch (13) of that second switch assembly (10) whose position in the second switching group series circuit (8) relative to the first end thereof corresponds to the position of the first switch assembly (9) in the first switching group series circuit (7) relative to the first end thereof, and
- each switch-mode power supply unit (11) is supplied with energy, by a semiconductor switch (13) of that switch pair to which the switch-mode power supply unit (11) is assigned, from an electrical voltage between the load terminals (19, 20) of the semiconductor switch (13).

2. Circuit arrangement (3) according to Claim 1, wherein the first switch assemblies (9) are arranged spatially one above another or next to one another in a first assembly stack (23) and the second switch assemblies (10) are arranged in a second assembly stack (24) in a manner corresponding to the first switch assemblies (9).

3. Circuit arrangement (3) according to Claim 2, wherein the switch assemblies (9, 10) of each assembly stack (23, 24) are arranged one above another or next to one another in the order of their switching group series circuit (7, 8).

4. Circuit arrangement (3) according to one of the preceding claims, wherein each switch-mode power supply unit (11) is supplied with energy by the semiconductor switch (13) of a first switch assembly (9).

5. Circuit arrangement (3) according to any of the preceding claims, wherein each switch assembly (9, 10) has a freewheeling diode (15) connected in parallel with the semiconductor switch (13).

6. Circuit arrangement (3) according to any of the preceding claims, wherein each capacitor bridge (5, 6) has a series circuit formed by a plurality of capacitors (25).

7. Circuit arrangement (3) according to any of the preceding claims, wherein the capacitor bridges (5, 6) are embodied identically.

8. Power convertor module (1), comprising
- a circuit arrangement (3) according to any of the preceding claims,
- a first module terminal (27), which is electrically connected to the first end of the first switching group series circuit (7), and
- a second module terminal (28), which is electrically connected to the second end of the first switching group series circuit (7).

## Revendications

1. Montage (3), comprenant
- plusieurs premiers modules (9) d'interrupteur montés en série, qui forment un premier circuit (7) série de groupes de coupure,
- un nombre, coïncidant avec le nombre de premiers modules (9) d'interrupteur, de deuxièmes modules (10) d'interrupteur montés en série, qui forment un deuxième circuit (8) série de groupes de coupure,
- un nombre, coïncidant avec le nombre de premiers modules (9) d'interrupteur, de blocs (11) d'alimentation de commutation, et
- deux ponts (5, 6) à condensateur ayant respectivement au moins un condensateur (25), dans lequel
- chaque module (9, 10) d'interrupteur a un interrupteur (13) à semiconducteur, ayant une borne ayant une borne (21) de commande et deux bornes (19, 20) de charge, et un circuit (17) d'attaque pour la commande de l'interrupteur (13) à semiconducteur par sa borne (21) de commande, dans lequel chaque interrupteur (13) à semiconducteur est un transistor bipolaire à grille isolée, dont ses bornes (19, 20) de charge sont son émetteur et son collecteur, et dont sa borne (21) de commande est sa grille, et les interrupteur (13) à semiconducteur respectivement de deux modules (9, 10) d'interrupteurs se suivant dans un circuit (7, 8) série de groupes de coupure sont reliés électriquement entre eux par une liaison électrique de l'émetteur de l'un des deux interrupteurs (13) à semiconducteur et du collecteur de l'autre des deux interrupteurs (13) à semiconducteur,
- un premier pont (5) à condensateur est relié électriquement au collecteur de l'interrupteur (13) à semiconducteur des modules (9) d'interrupteur à une première extrémité du circuit (7) série de groupes de coupure et à l'émetteur de l'interrupteur (13) à semiconducteur du module (10) d'interrupteur à une première extrémité du deuxième circuit (8) série de groupes de coupure,
- le deuxième pont (6) à condensateur est relié électriquement à l'émetteur de l'interrupteur (13) à semiconducteur du module (9) d'interrupteur à la deuxième extrémité du premier circuit (7) série de groupes de coupure et au collecteur de l'interrupteur (13) à semiconducteur du module (10) d'interrupteur à la deuxième extrémité du deuxième circuit (8) de série de groupes de coupure,
- chaque bloc (11) d'alimentation de coupure est associé à une paire d'interrupteurs (13) à semiconducteur et alimente en énergie le circuit (17) d'attaque des deux interrupteurs (13) à semiconducteur de la paire d'interrupteurs, dans lequel chaque paire d'interrupteurs est formée par l'interrupteur (13) à semiconducteur d'un premier module (9) d'interrupteur et par l'interrupteur (13) à semiconducteur du deuxième module (10) d'interrupteur, dont la position correspond, dans le deuxième circuit (8) série de groupes de coupure rapporté à sa première extrémité, à la position du premier module (9) d'interrupteur, dans le premier circuit (7) série de groupes de coupure, rapporté à sa première extrémité, et
- chaque bloc (11) d'alimentation de commutation est, par un interrupteur (13) à semiconducteur de la paire d'interrupteurs auquel est associé le bloc (11) d'alimentation de commutation, alimenté en énergie à partir d'une tension électrique entre les bornes (19, 20) de charge de l'interrupteur (13) à semiconducteur.

2. Montage (3) suivant la revendication 1, dans lequel les premiers modules (9) d'interrupteur sont disposés dans l'espace les uns sur les autres ou les uns à côté des autres en un premier empilement (23) de modules et les deuxièmes modules (10) d'interrupteur sont disposés d'une manière correspondant aux premiers modules (9) d'interrupteur dans un deuxième empilement (24) de modules.

3. Montage (3) suivant la revendication 2, dans lequel les modules (9, 10) d'interrupteur de chaque empilement (23, 24) de modules sont disposés les uns sur les autres ou les uns à côté des autres dans la succession de leurs circuits (7, 8) de groupes de coupure.

4. Montage (3) suivant l'une des revendications précédentes, dans lequel chaque bloc (11) d'alimentation de commutation est alimenté en énergie par l'interrupteur (13) à semiconducteur d'un premier module (9) d'interrupteur.

5. Montage (3) suivant l'une des revendications précédentes, dans lequel chaque module (9, 10) d'interrupteur a une diode (15) de roue libre montée en parallèle avec l'interrupteur (13) à semiconducteur.

6. Montage (3) suivant l'une des revendications précédentes, dans lequel chaque pont (5, 6) à condensateur a un circuit série de plusieurs condensateurs (25).

7. Montage (3) suivant l'une des revendications précédentes, dans lequel les ponts (5, 6) à condensateur sont constitués pareillement.

8. Module (1) de convertisseur, comprenant
- un montage (3) suivant l'une des revendications précédentes,
- une première borne (27) de module, qui est reliée électriquement à la première extrémité du premier circuit (7) série de groupes de coupure, et
- un deuxième borne (28) de module, qui est reliée électriquement à la deuxième extrémité du premier circuit (7) série de groupes de coupure.
